(19) Europäisches Patentamt / European Patent Office / Office européen des brevets

(11) **EP 3 447 914 A1**

(12) **EUROPEAN PATENT APPLICATION**
published in accordance with Art. 153(4) EPC

(43) Date of publication:
**27.02.2019 Bulletin 2019/09**

(51) Int Cl.:
***H03F 3/68*** *(2006.01)*

(21) Application number: **16902384.3**

(22) Date of filing: **18.05.2016**

(86) International application number:
**PCT/JP2016/064722**

(87) International publication number:
**WO 2017/199365 (23.11.2017 Gazette 2017/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation Chiyoda-ku Tokyo 100-8310 (JP)**

(72) Inventors:
• **KUWATA, Eigo Tokyo 100-8310 (JP)**

• **YAMANAKA, Koji Tokyo 100-8310 (JP)**
• **SUGIMOTO, Atsuo Tokyo 100-8310 (JP)**
• **KOYAMA, Hidetoshi Tokyo 100-8310 (JP)**
• **YAMAGUCHI, Yutarou Tokyo 100-8310 (JP)**

(74) Representative: **Pfenning, Meinig & Partner mbB Patent- und Rechtsanwälte Theresienhöhe 11a 80339 München (DE)**

(54) **DISTRIBUTION TYPE AMPLIFIER AND MULTISTAGE AMPLIFIER**

(57)    An input-side transmission line (2) transmitting an input signal; an output-side transmission line (3) transmitting an output signal; a plurality of transistors (5) amplifying the input signal transmitted by the input-side transmission line (2) and outputting the output signal which is the input signal after the amplifying; and an LC resonator (6) connected between an output terminal (5a) of a transistor being one of the plurality of transistors (5) and the output-side transmission line (3), the LC resonator (6) having a resonance frequency higher than an operation frequency of the transistor (5) are provided. Due to such a configuration, an output power and a power consumption can be reduced.

FIG. 1

EP 3 447 914 A1

Printed by Jouve, 75001 PARIS (FR)

Description

TECHNICAL FIELD

The present invention relates to a distributed amplifier in which a plurality of transistors is arranged between an input-side transmission line and an output-side transmission line and a multistage amplifier in which a plurality of distributed amplifiers is connected to form multiple stages.

BACKGROUND ART

An output-side circuit of a distributed amplifier disclosed in Non-Patent Literature 1 forms an unbalanced tournament-shaped circuit.
Due to the configuration of the output-side circuit forming an unbalanced tournament-shape circuit, it is possible to implement a broadband distributed amplifier.

CITATION LIST

NON-PATENT LITERATURE

Non-Patent Literature 1: C. Campbell, L. Taehun, V. Williams, K. Ming-Yih, T. Hua-Quen, P. Saunier, "A Wideband Power Amplifier MMIC Utilizing GaN on SiC HEMT Technology," 2008 CSICS, Oct. 2008.

SUMMARY OF INVENTION

TECHNICAL PROBLEM

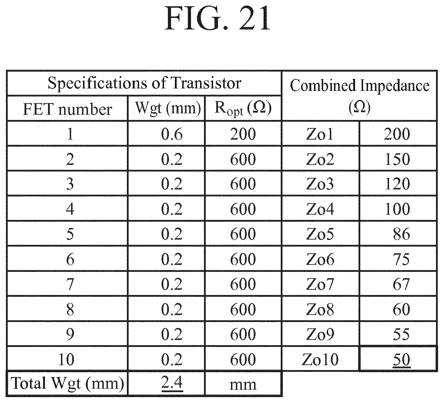

Since a conventional distributed amplifier is configured as described above, in a case where it is necessary to implement broadband frequency characteristics, an impedance conversion function cannot be provided to a wiring of an output-side circuit of the distributed amplifier. In a case where the output-side circuit is an unbalanced tournament type circuit and does not have a function of impedance conversion, with a given optimum load resistance per unit gate width of each transistor and a given condition to fix a terminal impedance, a total gate width of the whole amplifier is constant even when the number of transistors to be mounted or the gate width of each transistor is changed. Therefore, it is not possible to increase or decrease the output power. Therefore, in a case where the output power of a distributed amplifier is larger than desired output power, there is a problem that unnecessary power consumption occurs.
A specific example of the above conventional technique is shown as follows.
FIGS. 18 to 21 are explanatory tables illustrating the total gate width Wgt (mm) of the whole amplifier in a case where an optimum load resistance per unit gate width of a transistor is 120 ($\Omega \cdot$ mm) and a terminal impedance is 50 ($\Omega$).
FIG. 18 illustrates a case where the gate widths Wgt (mm) of all the transistors are equal and the number of transistors is ten, FIG. 19 illustrates a case where the gate widths Wgt (mm) of all the transistors are equal and the number of transistors is eight, and FIG. 20 illustrates a case where the gate widths Wgt (mm) of all the transistors are equal and the number of transistors is four.
In addition, FIG. 21 illustrates a case where the number of transistors is ten, the gate width of a transistor closest to an input terminal among the ten transistors is wider than the gate widths of the other transistors, and the gate widths of the other transistors are equal.

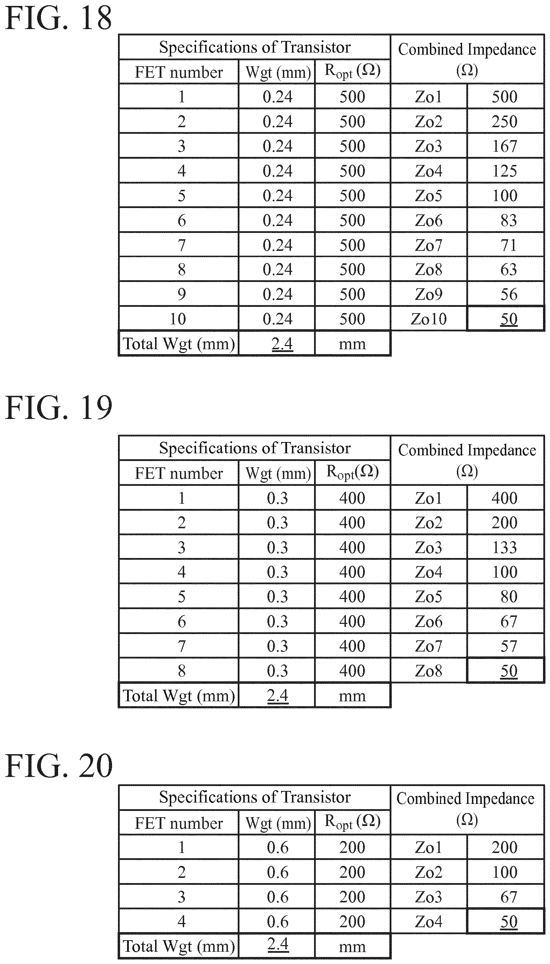

In FIG. 18 to FIG. 21, "FET number" represents the number for identifying each transistor which is allocated from the transistor closest to an input terminal in turn, "$R_{opt}$" represents an optimum load resistance per unit gate width in each transistor, each of Zo1 to Zo10 represents combined impedance when an output terminal of each transistor is viewed from the outside, and Zo corresponding to a transistor farthest from the input terminal represents a combined impedance at a part connected to an output terminal.
As illustrated in FIGS. 18 to 21, the total gate width Wgt (mm) of the whole amplifier is constant even when the number of mounted transistors or the gate width Wgt (mm) of each transistor changes. Therefore, unlike the tournament type amplifiers, in the conventional distributed amplifier, the output power can be neither increased nor decreased.
The present invention has been devised in order to solve the problem as described above, and an object of the present invention is to provide a distributed amplifier and a multistage amplifier capable of reducing output power and power consumption.

## SOLUTION TO PROBLEM

A distributed amplifier according to the present invention includes: an input-side transmission line transmitting an input signal; an output-side transmission line transmitting an output signal; a plurality of transistors amplifying the input signal transmitted by the input-side transmission line and outputting the output signal which is the input signal after the amplifying; and a resonator connected between an output terminal of a transistor being one of the plurality of transistors and the output-side transmission line, the resonator having a resonance frequency higher than an operation frequency of the transistor.

## ADVANTAGEOUS EFFECTS OF INVENTION

According to the present invention, since a resonator having a resonance frequency higher than an operation frequency of a transistor is connected between an output terminal of the transistor and an output-side transmission line, output power and power consumption can be reduced.

## BRIEF DESCRIPTION OF DRAWINGS

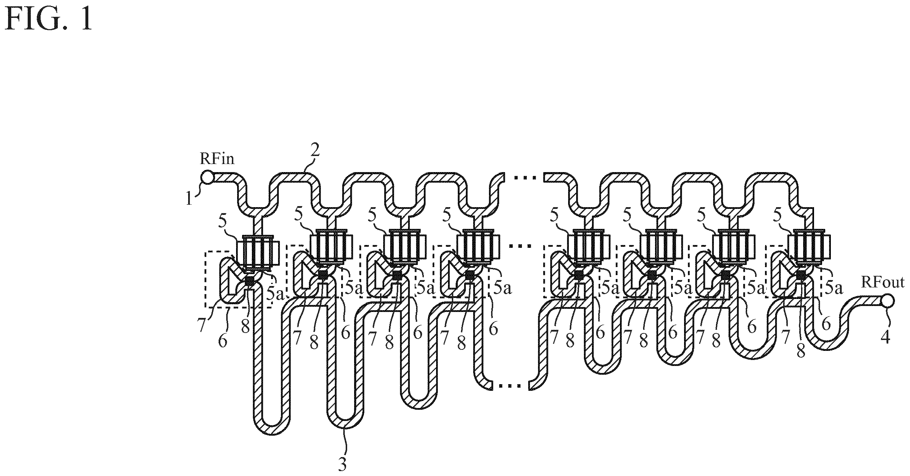

FIG. 1 is a configuration diagram illustrating a distributed amplifier according to a first embodiment of the present invention;

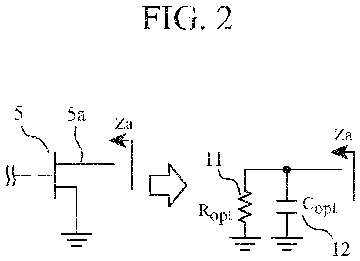

FIG. 2 is circuit diagrams in which an impedance Za of a circuit at an output terminal 5a of a transistor 5 is represented by replacing the circuit with a parallel circuit of an optimum load resistance 11 and a parasitic capacitance 12;

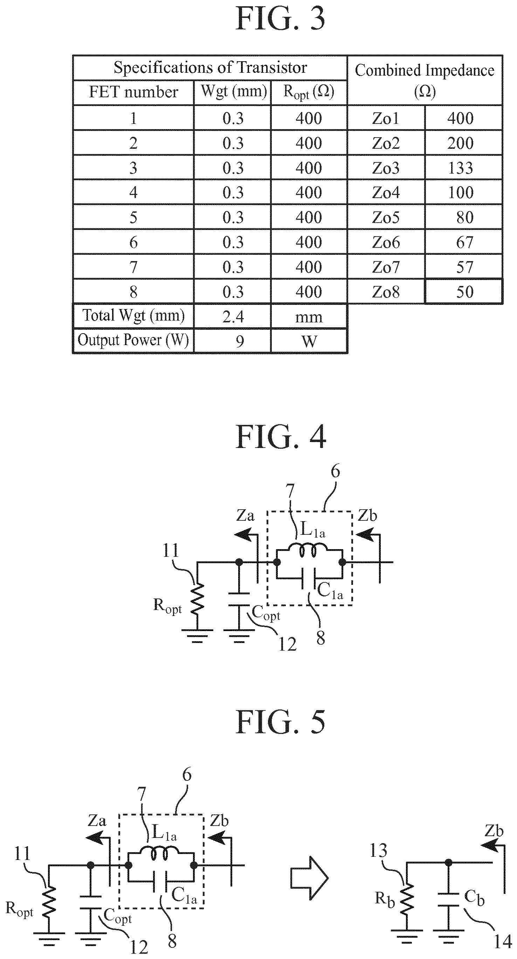

FIG. 3 is an explanatory table illustrating a total gate width Wgt (mm) and an output power (W) of the distributed amplifier in a case where the optimum load resistance 11 per unit gate width of the transistor 5 is 120 ($\Omega$ mm), a terminal impedance is 50 ($\Omega$), an output power density is 3.75 W/mm, and the number of transistors 5 is eight;

FIG. 4 is a circuit diagram illustrating the impedance Za and an impedance Zb in a state where an LC resonator 6 is connected to the output terminal 5a of the transistor 5;

FIG. 5 shows circuit diagrams in which a circuit in which the impedances Za and Zb are shown is replaced with a parallel circuit of a parallel resistor 13 and a parallel capacitance 14;

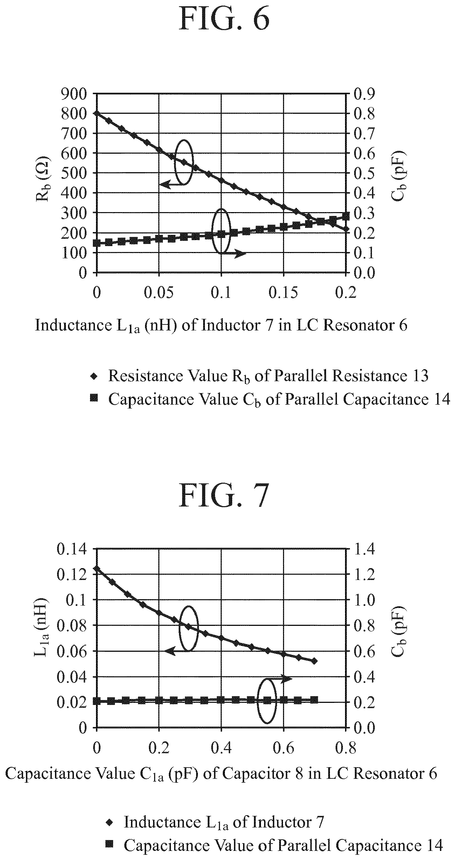

FIG. 6 is an explanatory graph illustrating an $L_{1a}$ dependence of a resistance value $R_b$ of the parallel resistor 13 and the capacitance value $C_b$ of the parallel capacitance 14 in a case where $C_{opt}$ is 0.15 (pF), $R_{opt}$ is 800 ($\Omega$), $C_{1a}$ is 0 (pF), and the frequency is 20 (GHz);

FIG. 7 is an explanatory graph illustrating an inductance $L_{1a}$ that allows a resistance value $R_b$ of the parallel resistor 13 to be 400 ($\Omega$) with the capacitance value $C_{1a}$ of the capacitor 8 in the LC resonator 6 being a variable parameter;

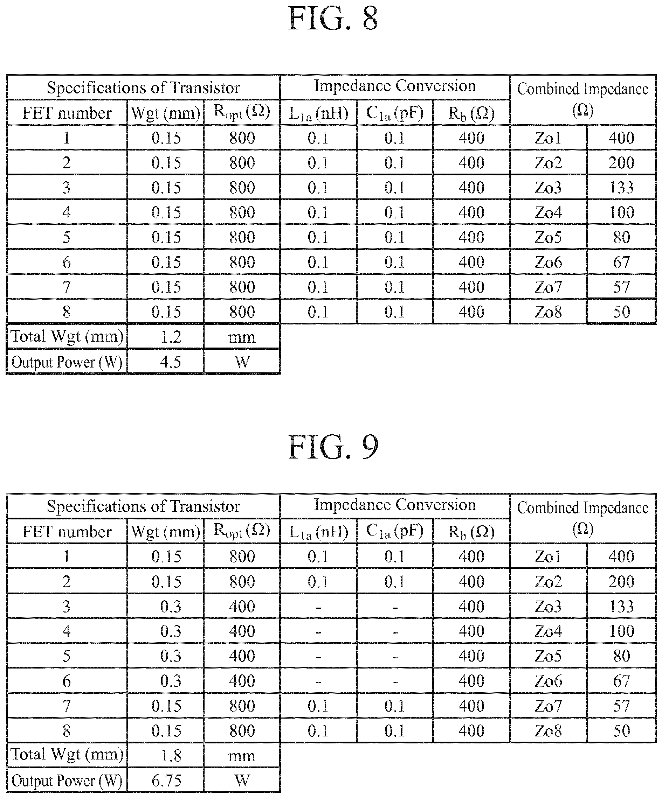

FIG. 8 is an explanatory table illustrating performance of the distributed amplifier according to the first embodiment of the present invention;

FIG. 9 is an explanatory table illustrating performance of the distributed amplifier in a case where an LC resonator 6 is connected to an output terminal 5a of each of four transistors 5 out of the eight transistors 5;

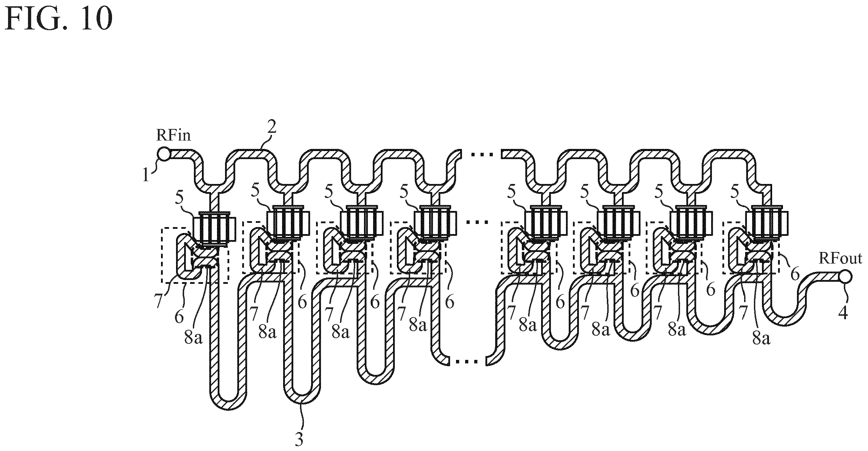

FIG. 10 is a configuration diagram illustrating another distributed amplifier according to the first embodiment of the present invention;

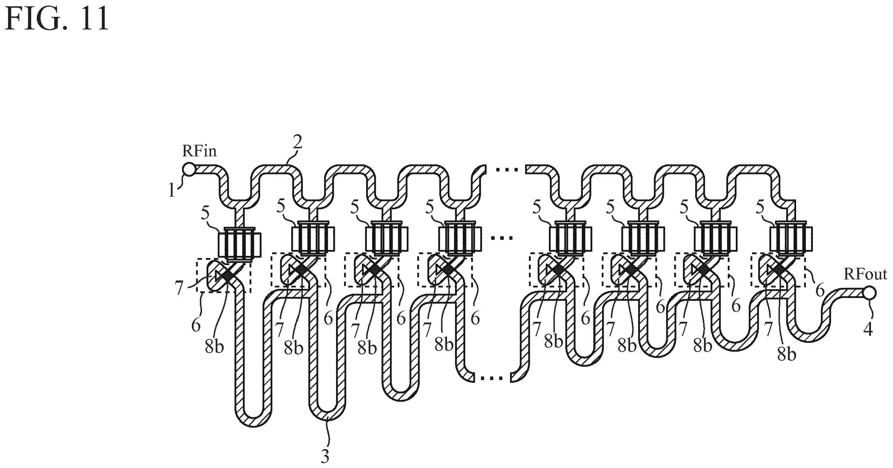

FIG. 11 is a configuration diagram illustrating still another distributed amplifier according to the first embodiment of the present invention;

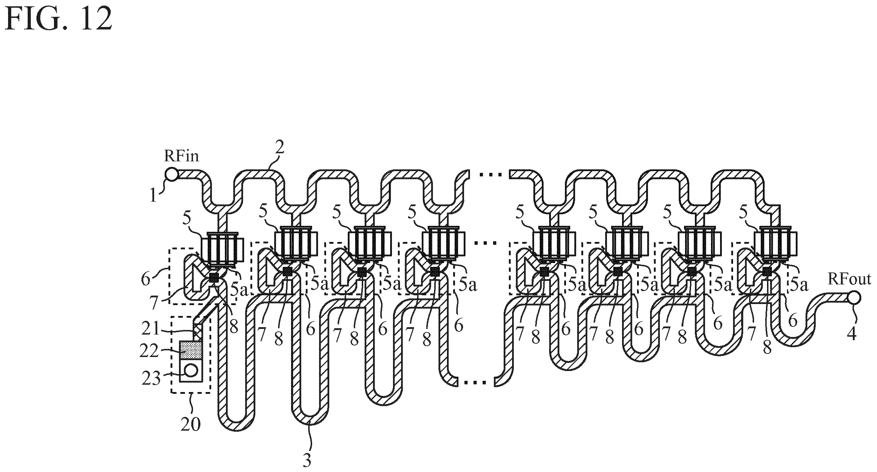

FIG. 12 is a configuration diagram illustrating a distributed amplifier according to a second embodiment of the present invention;

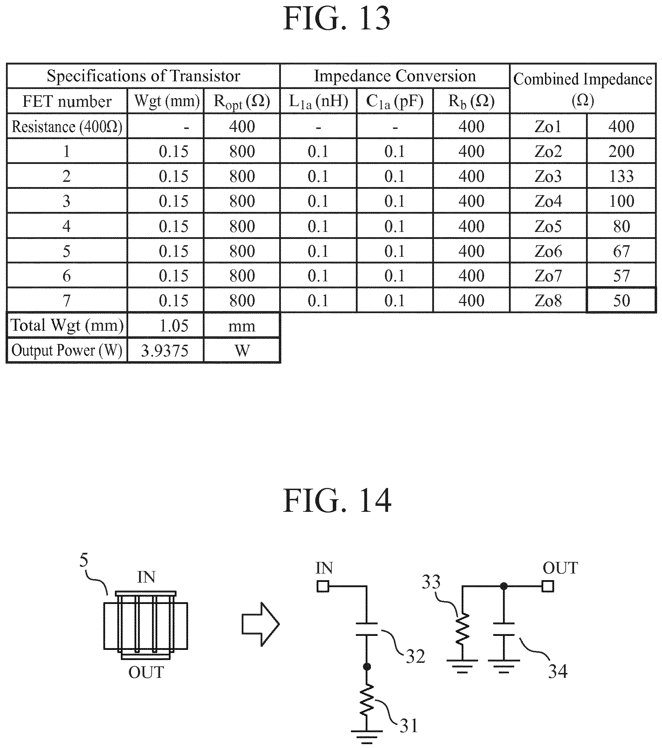

FIG. 13 is an explanatory table illustrating performance of the distributed amplifier according to the second embodiment of the present invention;

FIG. 14 is equivalent circuits illustrating an input terminal side and an output terminal side of a transistor 5 of a distributed amplifier according to a third embodiment of the present invention;

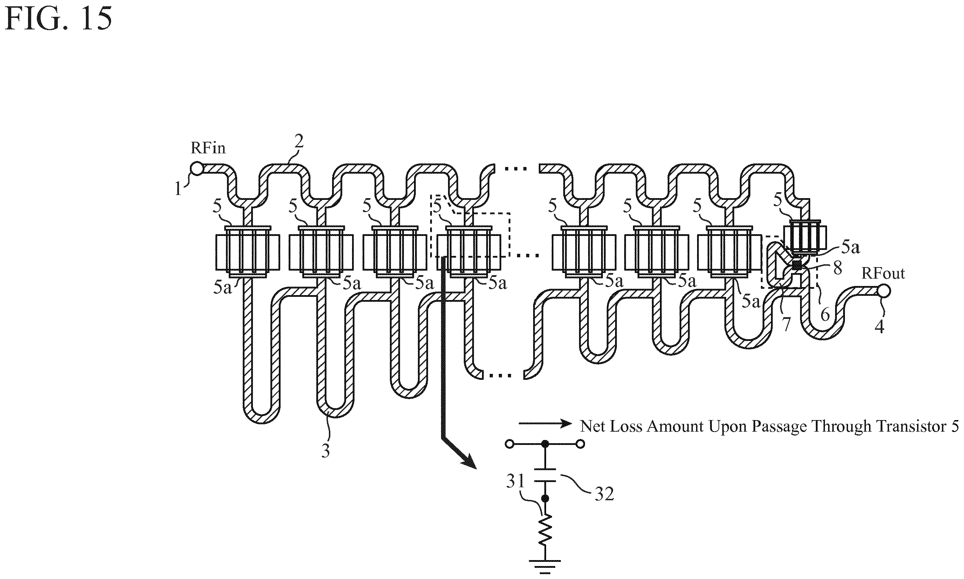

FIG. 15 is a configuration diagram illustrating the distributed amplifier according to the third embodiment of the present invention;

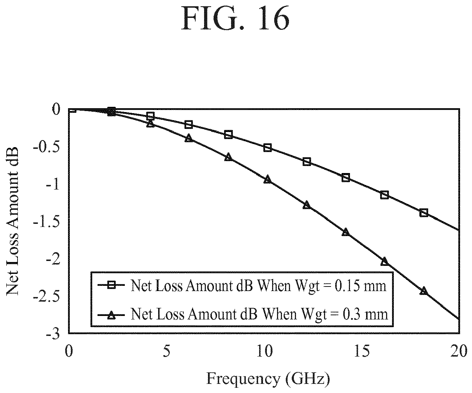

FIG. 16 is an explanatory graph illustrating calculation results of net loss amount upon passage through an input terminal in cases where a gate width Wgt of a transistor 5 is 0.3 (mm) and 0.15 (mm), respectively;

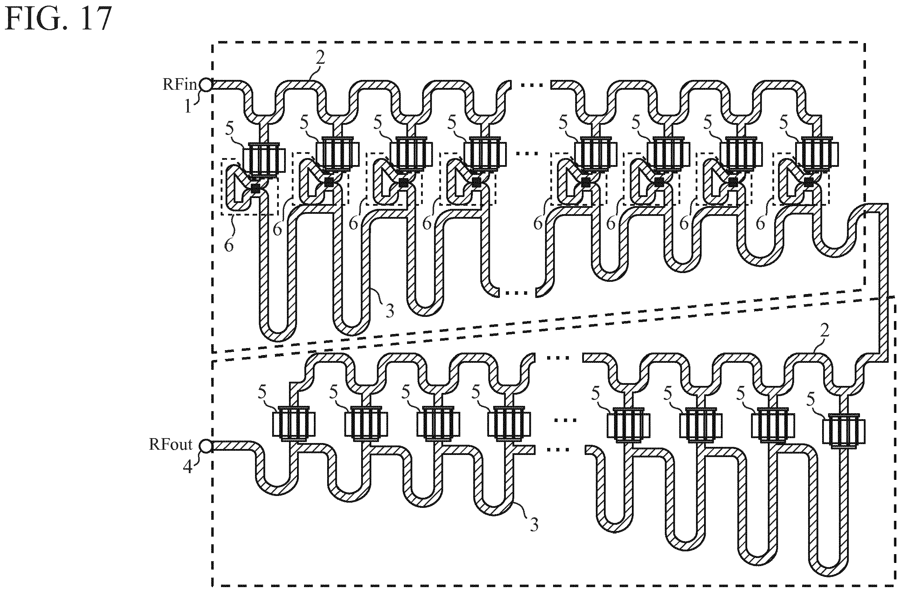

FIG. 17 is a configuration diagram illustrating a multistage amplifier according to a fourth embodiment of the present invention;

FIG. 18 is an explanatory table illustrating the total gate width Wgt (mm) of the whole amplifier in a case where the optimum load resistance per unit gate width of a transistor is 120 ($\Omega \cdot$ mm) and the terminal impedance is 50 ($\Omega$);

FIG. 19 is an explanatory table illustrating the total gate width Wgt (mm) of the whole amplifier in a case where the optimum load resistance per unit gate width of a transistor is 120 ($\Omega \cdot$ mm) and the terminal impedance is 50 ($\Omega$); FIG. 20 is an explanatory table illustrating the total gate width Wgt (mm) of the whole amplifier in a case where the optimum load resistance per unit gate width of a transistor is 120 ($\Omega \cdot$ mm) and the terminal impedance is 50 ($\Omega$); and FIG. 21 is an explanatory table illustrating the total gate width Wgt (mm) of the whole amplifier in a case where the optimum load resistance per unit gate width of a transistor is 120 ($\Omega \cdot$ mm) and the terminal impedance is 50 ($\Omega$).

## DESCRIPTION OF EMBODIMENTS

To describe the present invention further in detail, embodiments for carrying out the invention will be described below with reference to the accompanying drawings.

First Embodiment.

FIG. 1 is a configuration diagram illustrating a distributed amplifier according to a first embodiment of the invention.

In FIG. 1, an input terminal 1 receives a high frequency signal (input signal) to be amplified. In FIG. 1, the input terminal 1 is denoted as "RFin". As a high frequency signal, for example, a microwave signal, a millimeter wave signal, or the like can be considered.

An input-side transmission line 2 transmits a high frequency signal input from the input terminal 1.

An output-side transmission line 3 transmits a high frequency signal (output signal) amplified by a transistor 5.

An output terminal 4 is connected to the output-side transmission line 3 and outputs the high frequency signal transmitted by the output-side transmission line 3. In FIG. 1, the output terminal 4 is denoted as "RFout".

The transistor 5 amplifies the high frequency signal transmitted by the input-side transmission line 2 and outputs the amplified high frequency signal from an output terminal 5a.

An LC resonator 6 is formed by an inductor 7 and a capacitor 8 connected in parallel and is connected between the output terminal 5a of each transistor 5 and the output-side transmission line 3.

A resonance frequency of the LC resonator 6 is higher than an operation frequency of the transistor 5.

In the example of FIG. 1, the LC resonator 6 is connected between every output terminal 5a of all the transistors 5 and the output-side transmission line 3; however, it is sufficient if the LC resonator 6 is connected between the output terminals 5a of one or more transistors 5 and the output-side transmission line 3.

In the first embodiment, the example is described in which the LC resonator 6 in which the inductor 7 and the capacitor 8 are connected in parallel is connected between an output terminal 5a of a transistor 5 and the output-side transmission line 3; however, the resonator is not limited to an LC resonator. For example, instead of the LC resonator, an RC resonator in which a resistor and a capacitor are connected in parallel may be connected between an output terminal 5a of a transistor 5 and the output-side transmission line 3.

Next, the operation of the distributed amplifier will be described.

As illustrated in FIG. 2, an impedance Za at the output terminal 5a of the transistor 5 can be represented by replacing the transistor 5 with a parallel circuit of an optimum load resistance 11 and a parasitic capacitance 12.

FIG. 2 is circuit diagrams in which an impedance Za at an output terminal 5a of a transistor 5 is represented by replacing the circuit with a parallel circuit of an optimum load resistance 11 and a parasitic capacitance 12.

In FIG. 2, $R_{opt}$ indicates a resistance value of the optimum load resistance 11, and $C_{opt}$ indicates a capacitance value of the parasitic capacitance 12.

In order to compare a conventional distributed amplifier in which no LC resonator 6 is connected to an output terminal 5a of a transistor 5 and the distributed amplifier of the first embodiment in which the LC resonator 6 is connected to the output terminal 5a of each of the transistors 5, with various settings of parameters, the output power of the conventional distributed amplifier is calculated, which is illustrated in FIG. 3.

FIG. 3 is an explanatory table illustrating a total gate width Wgt (mm) and an output power (W) of the distributed amplifier in a case where an optimum load resistance 11 per unit gate width of a transistor 5 is 120 ($\Omega \cdot$ mm), a terminal impedance is 50 ($\Omega$), an output power density is 3.75 W/mm, and the number of transistors 5 is eight.

In FIG. 3, "FET number" represents the number for identifying each transistor 5 which is allocated in turn from the transistor 5 closest to an input terminal 1, each of Zo1 to Zo8 represents combined impedance when an output terminal 5a of each transistor 5 is viewed from the outside, and Zo of the transistor 5 farthest from the input terminal 1 represents a combined impedance at a part connected to an output terminal 4.

The total gate width Wgt (mm) represents the sum of gate widths Wgt of all the transistors 5 included in the distributed amplifier, and the output power (W) represents the output power of the distributed amplifier as a whole.

An output power (W) of a transistor 5 and an optimum load resistance 11 are parameters determined in accordance with the gate width Wgt of the transistor 5. In other words, when the optimum load resistance 11 per unit gate width in the transistor 5 is determined, the output power (W) of the transistor 5 is uniquely determined.

Therefore, if a relationship between the optimum load resistance 11 per unit gate width and the output power (W) in the transistor 5 can be changed, the output power of the distributed amplifier can be reduced.

FIG. 4 is a circuit diagram illustrating impedances Za and Zb in a state where an LC resonator 6 is connected to the output terminal 5a of the transistor 5.

In FIG. 4, $L_{1a}$ represents an inductance of an inductor 7 in the LC resonator 6, and $C_{1a}$ represents a capacitance value of a capacitor 8 in the LC resonator 6.

The impedance Zb represents an impedance when the transistor 5 is viewed from a connection point between the LC resonator 6 and the output-side transmission line 3 and is represented by the following equation (1).

$$Zb = \frac{R_{opt}\left(1 - j\omega C_{opt}R_{opt}\right)}{1 + \omega^2 C_{opt}{}^2 R_{opt}{}^2} + \frac{j\omega L_{1a}}{1 - \omega^2 L_{1a}C_{1a}} \qquad (1)$$

In equation (1), $\omega$ represents the angular frequency.

As illustrated in FIG. 5, the circuit of FIG. 4 showing the impedances Za and Zb can be replaced by a parallel circuit of a parallel resistor 13 and a parallel capacitance 14.

FIG. 5 shows circuit diagrams in which a circuit in which the impedances Za and Zb are shown is preplaced with a parallel circuit of a parallel resistor 13 and a parallel capacitance 14.

In FIG. 5, $R_b$ represents a resistance value of the parallel resistor 13, and $C_b$ represents a capacitance value of the parallel capacitance 14.

The resistance value $R_b$ of the parallel resistor 13 is expressed by the following equation (2), and the capacitance value $C_b$ of the parallel capacitance 14 is expressed by the following equation (3).

$$R_b = real\left(\frac{1}{\dfrac{R_{opt}\left(1 - j\omega C_{opt}R_{opt}\right)}{1 + \omega^2 C_{opt}{}^2 R_{opt}{}^2} + \dfrac{j\omega L_{1a}}{1 - \omega^2 L_{1a}C_{1a}}}\right) \qquad (2)$$

$$C_b = \frac{imaginary\left(\dfrac{1}{\dfrac{R_{opt}\left(1 - j\omega C_{opt}R_{opt}\right)}{1 + \omega^2 C_{opt}{}^2 R_{opt}{}^2} + \dfrac{j\omega L_{1a}}{1 - \omega^2 L_{1a}C_{1a}}}\right)}{\omega} \qquad (3)$$

In equation (2), "real ()" is a symbol of operation to extract the real part in the parentheses, and in equation (3), "imaginary ()" is a symbol of operation to extract the imaginary part in the parentheses.

FIG. 6 is an explanatory graph illustrating the $L_{1a}$-dependence of the resistance value $R_b$ of the parallel resistor 13 and the capacitance value $C_b$ of the parallel capacitance 14 in a case where $C_{opt}$ is 0.15 (pF), $R_{opt}$ is 800 ($\Omega$), $C_{1a}$ is 0 (pF), and the frequency is 20 (GHz).

As apparent from FIG. 6, as the inductance $L_{1a}$ of the inductor 7 in the LC resonator 6 increases, the resistance value $R_b$ of the parallel resistor 13 decreases, and the capacitance value $C_b$ of the parallel capacitance 14 increases.

FIG. 7 is an explanatory graph illustrating the inductance $L_{1a}$ that allows the resistance value $R_b$ of the parallel resistor 13 to be 400 ($\Omega$) with the capacitance value $C_{1a}$ of the capacitor 8 in the LC resonator 6 being a variable parameter.

As is apparent from FIG. 7, by increasing the capacitance value $C_{1a}$ of the capacitor 8 in the LC resonator 6, it is possible to decrease the inductance $L_{1a}$ of the inductor 7 necessary for realizing the same resistance value $R_b$. In other words, it is possible to implement a desired parallel resistor 13 with a small inductor 7.

However, in a case where the resonance frequency of the inductor 7 and the capacitor 8 overlaps with the operating band of the distributed amplifier, in a state where the LC resonator 6 is connected with the output terminal 5a of the transistor 5 in series, a high frequency signal output from the output terminal 5a of the transistor 5 cannot pass through the LC resonator 6, and thus the high frequency signal output from the output terminal 5a of the transistor 5 cannot reach the output terminal 4.

Therefore, the resonance frequency of the inductor 7 and the capacitor 8 needs to be higher than the operation frequency of the transistor 5.

A comparison is made between the conventional distributed amplifier in which no LC resonator 6 is connected to an output terminal 5a of a transistor 5 and the distributed amplifier of the first embodiment in which the LC resonator 6 is connected to the output terminals 5a of the transistors 5 with various settings of parameters.

As for the performance of the conventional distributed amplifier, the output power is 9 (W) as illustrated in FIG. 3 in a case where an optimum load resistance 11 per unit gate width of the transistor 5 is 120 ($\Omega \cdot$ mm), a parasitic capacitance per unit gate width of the transistor 5 is 1 pF/mm, a terminal impedance is 50 ($\Omega$), a high band edge frequency of the distributed amplifier is 20 (GHz), and the number of transistors 5 is eight.

In this first embodiment, the performance of the distributed amplifier illustrated in FIG. 8 is achieved when gate widths Wgt of the eight transistors 5 are set to 0.15 (mm) such that the output power is decreased to 4.5 (W) which is half of the output power of the conventional distributed amplifier, and an inductance $L_{1a}$ of the inductor 7 and a capacitance value $C_{1a}$ of the capacitor 8 are set such that a resistance value $R_b$ of the parallel resistor 13 is 400 ($\Omega$).

FIG. 8 is an explanatory table illustrating performance of the distributed amplifier according to the first embodiment of the present invention.

In the distributed amplifier of the first embodiment, as described above, the output power is 4.5 (W).

In the first embodiment, the LC resonator 6 is connected to every output terminal 5a of the eight transistors 5; however, even in a case where the LC resonator 6 is connected to an output terminal 5a of a part of the transistors 5, it is possible to change the output power.

FIG. 9 is an explanatory table illustrating performance of the distributed amplifier in a case where an LC resonators 6 is connected to an output terminals 5 of each of four transistors 5 out of the eight transistors 5. The output power is 6.75 (W). The output power of 6.75 (W) is reduced to 75% compared with the output power of the conventional distributed amplifier.

As is apparent from the above, according to the first embodiment, since the LC resonator 6 having the resonance frequency higher than the operation frequency of a transistor 5 is connected between an output terminal 5a of the transistor 5 and the output-side transmission line 3, an effect of reducing the output power can be achieved.

Since all the circuit elements applied to the distributed amplifier of the first embodiment are reactive parts, no loss occurs. That is, regardless of the presence or absence of the applied circuit, the operation efficiency of the distributed amplifier does not change. Therefore, the effect of reducing the power consumption can be obtained as much as the output power of the distributed amplifier is reduced.

Furthermore, since the size of any number of transistors 5 can be changed, the distributed amplifier can be designed freely in accordance with required output power.

In the first embodiment, the LC resonator 6 in which the inductor 7 and the capacitor 8 are connected in parallel has been described; however, as for the capacitor 8 of the LC resonator 6, a capacitor 8a formed by coupling between pieces of wiring may be used as illustrated in FIG. 10.

Furthermore as illustrated in FIG. 11, the inductor 7 of the LC resonator 6 may be formed by loop-shaped wiring, and an inter-wiring capacitance 8b formed at an intersection of the loop-shaped wiring may be used as a capacitor 8 of an LC resonator 6. Furthermore, a metal insulator metal (MIM) capacitor sandwiching a dielectric between the pieces of wiring may be used for the capacitor 8 of the LC resonator 6.

Second Embodiment.

In the first embodiment, an example in which no terminating resistor is connected to the output-side transmission line 3 has been described. In this second embodiment, an example in which a terminating resistor is connected to an output-side transmission line 3 will be described.

FIG. 12 is a configuration diagram illustrating a distributed amplifier according to the second embodiment of the present invention. In FIG. 12, the same reference numerals as those in FIG. 1 represent the same or corresponding parts, and thus descriptions thereof are omitted.

A terminating resistor 20 includes a resistor 21, a capacitor 22 for DC cutting, and a via hole 23, and one end of the terminal resistor 20 is connected to an output-side transmission line 3.

An end of the resistor 21 is connected to the output-side transmission line 3.

An end of the capacitor 22 is connected to the other end of the resistor 21 in order to cut off DC components.

The via hole 23 is connected to a ground (not illustrated) and terminates the resistor 21 via the capacitor 22.

In this second embodiment, a mode in which the terminating resistor 20 is connected to the output-side transmission line 3 while the number of transistors 5 included in the distributed amplifier is decreased will be described.

In the first embodiment, performance of the distributed amplifier in the case where eight transistors 5 are mounted is illustrated in FIG. 8.

In FIG. 13, performance of the distributed amplifier in the second embodiment is illustrated. In this embodiment, seven transistors 5 having the same size as those of the transistors 5 included in the distributed amplifier in the first embodiment are mounted on the distributed amplifier, and the terminating resistor 20 is connected to the output-side transmission line 3.

FIG. 13 is an explanatory table illustrating the performance of the distributed amplifier according to the second embodiment of the present invention.

As is apparent from a comparison between FIG. 8 and FIG. 13, by decreasing the number of transistors 5, the output power (W) of the distributed amplifier as a whole is decreased.

By connecting the terminating resistor 20, it is possible to decrease the number of transistors 5 without changing the gate widths Wgt of the transistors 5.

As effects of connecting the terminating resistor 20, the following effects are also obtained.

A first effect is improvement in frequency characteristics in the distributed amplifier.

A parasitic capacitance 12 of the transistor 5, an inductor 7 of an LC resonator 6 and a capacitor 8 of the LC resonator 6 are reactive components and thus have frequency characteristics. Therefore, the frequency characteristics of the distributed amplifier has a ripple component.

By mounting the resistor 21 having no reactive component in the distributed amplifier, the resistor 21 acts as a damping resistor. Therefore, the resistor 21 suppresses the ripple component, and as a result, the frequency characteristic of the distributed amplifier can be improved.

As a second effect, the configuration of this embodiment can be diverted to a power supply bias circuit.

For example in a distributed amplifier with small output power, since a power supply current is very small, a resistance on a power supply path does not matter. Therefore, for example, by applying power source from the connection point between the resistor 21 and the capacitor 22, the power supply and the distributed amplifier can be blocked in microwave frequency.

The capacitor 22 for DC cutting in the terminating resistor 20 may be an MIM capacitor, a coupling capacitance between pieces of wiring, or a chip capacitor.

In the second embodiment, the via hole 23 is provided. However in a case where the transistor 5 corresponding to the via hole 23 operates in a balanced manner using a balun or the like, by connecting the other ends of the capacitors 22 for DC cutting in the respective transistors 5, a virtual short is formed, and thus the via hole 23 is not required to be formed.

Alternatively, in a case where ground is wired on a surface of a substrate on which the distributed amplifier is formed, the capacitor 22 for DC cutting may be connected to the ground arranged on the surface of the substrate.

In this second embodiment, the example in which the terminating resistor 20 is applied to the distributed amplifier of FIG. 1 has been described; however the present embodiment is not limited to this example. For example, the terminating resistor 20 may be applied to the distributed amplifiers of FIG. 10 or 11.

Third Embodiment.

In a third embodiment, a distributed amplifier in which a gate width Wgt of a first transistor included in a plurality of transistors 5 is narrower than a gate width Wgt of a second transistor included in the plurality of transistors 5, and a distance from an output terminal 4 to the first transistor is shorter than a distance from the output terminal 4 to the second transistor will be described.

In the third embodiment, for convenience of explanation, it is assumed that the first transistor has the shortest distance from the output terminal 4 among the plurality of transistors 5. Furthermore, any transistor 5 other than the first transistor can be used as the second transistor, and for example, the second transistor is assumed to have the longest distance from the output terminal 4.

The transistor 5 can be understood by dividing it into an equivalent circuit on the input terminal side and an equivalent circuit on the output terminal side on the basis of the Miller effect.

FIG. 14 shows equivalent circuits of an input terminal side and an output terminal side of a transistor 5 of the distributed amplifier according to the third embodiment of the present invention.

The input terminal side of the transistor 5 is represented by a parasitic resistance 31 and an input capacitance 32, and the output terminal side of the transistor 5 is represented by a parasitic resistance 33 and an output capacitance 34.

For example, it is assumed that, in the transistor 5, the input capacitance 32 per unit gate width is 2 (pF/mm) and that the parasitic resistance 31 is 1 ($\Omega \cdot$ mm).

FIG. 15 is a configuration diagram illustrating the distributed amplifier according to the third embodiment of the present invention. In FIG. 15, the same reference numerals as those in FIG. 1 represent the same or corresponding parts, and thus descriptions thereof are omitted.

In FIG. 15, for convenience of explanation, an equivalent circuit on an input terminal side of one of the plurality of transistors 5 is illustrated.

Furthermore in FIG. 15, an LC resonator 6 is connected to only one transistor 5; however, the LC resonator 6 may be connected to every transistor 5 like in the first and second embodiments. Moreover, like in the second embodiment, a terminating resistor 20 may be connected to an output-side transmission line 3.

FIG. 16 is an explanatory graph illustrating calculation results of net loss amount upon passage through the input terminal in cases where a gate width Wgt of a transistor 5 is 0.3 (mm) and 0.15 (mm).

A calculation formula of the net loss amount upon passage through an input terminal of a transistor 5 is expressed by the following equation (4).

$$\mathrm{Net\ Loss\ Amount} = 10 \times log_{10}\left( \frac{S_{21}{}^2}{1 - S_{11}{}^2} \right) \qquad (4)$$

In equation (4), $S_{11}$ and $S_{21}$ are S parameters.

It is understood from FIG. 16 that, when power of a high frequency signal input from an input terminal 1 of the distributed amplifier passes through a transistor 5, the power of the high frequency signal changes into heat at the parasitic resistance 31 and that the smaller a gate width Wgt of the transistor 5 is, the smaller a loss amount becomes. In addition, the farther the position is from the input terminal 1, the smaller the arrival power is.

In addition, since the number of via holes at a source electrode of the transistor 5 does not change, when the size of a transistor is decreased, a source inductor per unit gate width decreases, and the gain increases.

Therefore, in this third embodiment, the gate width Wgt of a transistor 5 the power arriving thereto is decreased due to the net loss in the input circuit, that is, the transistor 5 having the shortest distance from the output terminal 4 among the plurality of transistors 5 is designed to be the narrowest.

With this configuration, the gain of the transistor 5 can be increased so as to compensate for the net loss, and thereby the gain of the distributed amplifier as a whole can be increased.

In the third embodiment, an example in which an LC resonator 6 formed by connecting an inductor 7 and a capacitor 8 in parallel is included has been described; however, as for the capacitor 8 of the LC resonator 6, a capacitor 8a formed by coupling between pieces of wirings may be used as illustrated in FIG. 10.

Furthermore as illustrated in FIG. 11, the inductor 7 of the LC resonator 6 may be formed by loop-shaped wiring, and an inter-wiring capacitance 8b generated at an intersection in the loop-shaped wiring may be used as the capacitor 8 of the LC resonator 6. Furthermore, an MIM capacitor formed by sandwiching a dielectric between the pieces of wiring may be used as the capacitor 8 of the LC resonator 6.

Fourth Embodiment.

In a fourth embodiment, a multistage amplifier in which a plurality of distributed amplifiers is connected to form multiple stages will be described.

FIG. 17 is a configuration diagram illustrating a multistage amplifier according to the fourth embodiment of the invention. In FIG. 17, the same symbols as those in FIG. 1 represent the same or corresponding parts, and thus descriptions thereof are omitted.

FIG. 17 illustrates an example of a multistage amplifier of two stages in which a distributed amplifier of a driver stage (previous stage) is implemented by the distributed amplifier described in the first embodiment, and a distributed amplifier of an output stage is implemented by a conventional distributed amplifier. The conventional distributed amplifier refers to a distributed amplifier in which no LC resonator 6 is connected to output terminals 5a of transistors 5.

FIG. 17 illustrates an example in which the distributed amplifier of the driver stage is implemented by the distributed amplifier described in the first embodiment; however, the distributed amplifier illustrated in the second or third embodiment may be applied to the distributed amplifier of the driver stage.

By implementing the distributed amplifier of the driver stage by the distributed amplifier described in the first embodiment and the distributed amplifier of the output stage by a conventional distributed amplifier, it is possible to reduce power consumption of the driver stage, thereby reducing power consumption of the entire multistage amplifier.

Hereinafter, a comparison is made between power consumption in a case where each of the distributed amplifiers of the driver stage and the output stage is implemented by a conventional distributed amplifier and power consumption in the case where the distributed amplifier of the driver stage is implemented by the distributed amplifier described in the first embodiment and the distributed amplifier of the output stage is implemented by a conventional distributed amplifier.

Note that it is assumed for the sake of convenience of explanation that the operation efficiency of the conventional distributed amplifier and the operation efficiency of the distributed amplifier described in the first embodiment are both 50%.

In addition, in this example it is assumed that the performance of the conventional distributed amplifier is as illustrated in FIG. 3 and that the performance of the distributed amplifier described in the first embodiment is as illustrated in FIG. 8.

In this case, the output power of the conventional distributed amplifier is 9 (W), and the output power of the distributed amplifier described in the first embodiment is 4.5 (W). Thus, the power consumption $P_1$ in the case where the distributed amplifiers of the driver stage and the output stage are implemented by the conventional distributed amplifiers is expressed by the following equation (5).

$$P_1 = 9 \times 0.5 + 9 \times 0.5 = 9(W) \qquad (5)$$

On the other hand, the power consumption $P_2$ when the distributed amplifier of the driver stage is implemented by the distributed amplifier described in the first embodiment and the distributed amplifier of the output stage is implemented by the conventional distributed amplifier is expressed by the following equation (6).

$$P_2 = 4.5 \times 0.5 + 9 \times 0.5 = 6.75(W) \qquad (6)$$

Therefore, when the distributed amplifier of the driver stage is implemented by the distributed amplifier described in the first embodiment and the distributed amplifier of the output stage is implemented by the conventional distributed amplifier, the power consumption can be reduced to 75% (= (6.75/9) $\times$ 100%) as compared with the case where the distributed amplifiers of the driver stage and the output stage are implemented by the conventional distributed amplifiers.

In the fourth embodiment, an example of the multistage amplifier of two stages in which the distributed amplifier of the driver stage is implemented by the distributed amplifier described in the first embodiment and the distributed amplifier of the output stage is implemented by the conventional distributed amplifier has been described; however, for example in an amplifier such as a low noise amplifier (LNA) that needs to withstand high power in a driver stage thereof, it is possible to implement a high power withstanding property and low power consumption as long as the distributed amplifier of the driver stage is implemented by a conventional distributed amplifier and the distributed amplifier of the output stage is implemented by any of the distributed amplifiers described in the first to third embodiments.

Furthermore, in the above explanation of the fourth embodiment, a multistage amplifier in which two distributed amplifiers are connected to form multiple stages is described; however, the multistage amplifier may include three or more distributed amplifiers connected to form multiple stages in which one or more distributed amplifiers are implemented by the distributed amplifiers described in any of the first to third embodiments.

Note that, within the scope of the present invention, the present invention may include any combination of embodiments, and any component of the embodiments may be modified or omitted.

## INDUSTRIAL APPLICABILITY

The present invention is suitable for a distributed amplifier in which a plurality of transistors are arranged between an input-side transmission line and an output-side transmission line.

The present invention is further suitable for a multistage amplifier in which a plurality of distributed amplifiers is connected to form multiple stages.

## REFERENCE SIGNS LIST

1: Input terminal, 2: Input-side transmission line, 3: Output-side transmission line, 4: Output terminal, 5: Transistor, 5a: Output terminal, 6: LC resonator, 7: Inductor, 8: Capacitor, 8a: Capacitor, 8b: Inter-wiring capacitance, 11: Optimum load resistance, 12: Parasitic capacitance, 13: Parallel resistor, 14: Parallel capacitance, 20: Terminating resistor, 21: Resistor, 22: Capacitor, 23: Via hole, 31: Parasitic resistance, 32: Input capacitance, 33: Parasitic resistance, 34: Output capacitance.

## Claims

1. A distributed amplifier comprising:

    an input-side transmission line transmitting an input signal;
    an output-side transmission line transmitting an output signal;
    a plurality of transistors amplifying the input signal transmitted by the input-side transmission line and outputting the output signal which is the input signal after the amplifying; and

a resonator connected between an output terminal of a transistor being one of the plurality of transistors and the output-side transmission line, the resonator having a resonance frequency higher than an operation frequency of the transistor.

2. The distributed amplifier according to claim 1, wherein a terminating resistor is connected to the output-side transmission line.

3. The distributed amplifier according to claim 1,
   wherein a gate width of a first transistor included in the plurality of transistors is narrower than a gate width of a second transistor included in the plurality of transistors, and
   a distance from an output terminal connected to the output-side transmission line to the first transistor is shorter than a distance from the output terminal to the second transistor.

4. A multistage amplifier comprising a plurality of distributed amplifiers connected to form multiple stages, each of the plurality of distributed amplifiers comprising:

   an input-side transmission line transmitting an input signal;
   an output-side transmission line transmitting an output signal; and
   a plurality of transistors arranged between the input-side transmission line and the output-side transmission line, amplifying the input signal transmitted by the input-side transmission line, and outputting the output signal which is the input signal after the amplifying to the output-side transmission line, and
   a resonator is connected, in one or more distributed amplifiers out of the plurality of distributed amplifiers connected to form multiple stages, between an output terminal of one of the plurality of transistors and the output-side transmission line, the resonator having a resonance frequency higher than an operation frequency of the one of the plurality of transistors.

5. The multistage amplifier according to claim 4,
   wherein two distributed amplifiers out of the plurality of distributed amplifiers are connected to form multiple stages, and
   in a distributed amplifier of a preceding stage in the two distributed amplifiers, between an output terminal of one of the plurality of transistors and the output-side transmission line, a resonator having a resonance frequency higher than an operation frequency of the one of the plurality of transistors is connected.

FIG. 1

# FIG. 2

# FIG. 3

| Specifications of Transistor | | | Combined Impedance (Ω) | |
|---|---|---|---|---|
| FET number | Wgt (mm) | $R_{opt}$ (Ω) | | |
| 1 | 0.3 | 400 | Zo1 | 400 |
| 2 | 0.3 | 400 | Zo2 | 200 |
| 3 | 0.3 | 400 | Zo3 | 133 |
| 4 | 0.3 | 400 | Zo4 | 100 |
| 5 | 0.3 | 400 | Zo5 | 80 |
| 6 | 0.3 | 400 | Zo6 | 67 |
| 7 | 0.3 | 400 | Zo7 | 57 |
| 8 | 0.3 | 400 | Zo8 | 50 |
| Total Wgt (mm) | 2.4 | mm | | |
| Output Power (W) | 9 | W | | |

# FIG. 4

# FIG. 5

# FIG. 6

Inductance $L_{1a}$ (nH) of Inductor 7 in LC Resonator 6

♦ Resistance Value $R_b$ of Parallel Resistance 13
■ Capacitance Value $C_b$ of Parallel Capacitance 14

# FIG. 7

Capacitance Value $C_{1a}$ (pF) of Capacitor 8 in LC Resonator 6

♦ Inductance $L_{1a}$ of Inductor 7
■ Capacitance Value of Parallel Capacitance 14

# FIG. 8

| Specifications of Transistor | | | Impedance Conversion | | | Combined Impedance ($\Omega$) | |
|---|---|---|---|---|---|---|---|
| FET number | Wgt (mm) | $R_{opt}$ ($\Omega$) | $L_{1a}$ (nH) | $C_{1a}$ (pF) | $R_b$ ($\Omega$) | | |
| 1 | 0.15 | 800 | 0.1 | 0.1 | 400 | Zo1 | 400 |
| 2 | 0.15 | 800 | 0.1 | 0.1 | 400 | Zo2 | 200 |
| 3 | 0.15 | 800 | 0.1 | 0.1 | 400 | Zo3 | 133 |
| 4 | 0.15 | 800 | 0.1 | 0.1 | 400 | Zo4 | 100 |
| 5 | 0.15 | 800 | 0.1 | 0.1 | 400 | Zo5 | 80 |
| 6 | 0.15 | 800 | 0.1 | 0.1 | 400 | Zo6 | 67 |
| 7 | 0.15 | 800 | 0.1 | 0.1 | 400 | Zo7 | 57 |
| 8 | 0.15 | 800 | 0.1 | 0.1 | 400 | Zo8 | 50 |
| Total Wgt (mm) | 1.2 | mm | | | | | |
| Output Power (W) | 4.5 | W | | | | | |

# FIG. 9

| Specifications of Transistor | | | Impedance Conversion | | | Combined Impedance ($\Omega$) | |
|---|---|---|---|---|---|---|---|
| FET number | Wgt (mm) | $R_{opt}$ ($\Omega$) | $L_{1a}$ (nH) | $C_{1a}$ (pF) | $R_b$ ($\Omega$) | | |
| 1 | 0.15 | 800 | 0.1 | 0.1 | 400 | Zo1 | 400 |
| 2 | 0.15 | 800 | 0.1 | 0.1 | 400 | Zo2 | 200 |
| 3 | 0.3 | 400 | - | - | 400 | Zo3 | 133 |
| 4 | 0.3 | 400 | - | - | 400 | Zo4 | 100 |
| 5 | 0.3 | 400 | - | - | 400 | Zo5 | 80 |
| 6 | 0.3 | 400 | - | - | 400 | Zo6 | 67 |
| 7 | 0.15 | 800 | 0.1 | 0.1 | 400 | Zo7 | 57 |
| 8 | 0.15 | 800 | 0.1 | 0.1 | 400 | Zo8 | 50 |
| Total Wgt (mm) | 1.8 | mm | | | | | |
| Output Power (W) | 6.75 | W | | | | | |

FIG. 10

FIG. 11

FIG. 12

# FIG. 13

| Specifications of Transistor | | | Impedance Conversion | | | Combined Impedance ($\Omega$) | |
|---|---|---|---|---|---|---|---|
| FET number | Wgt (mm) | $R_{opt}$ ($\Omega$) | $L_{1a}$ (nH) | $C_{1a}$ (pF) | $R_b$ ($\Omega$) | | |
| Resistance (400$\Omega$) | - | 400 | - | - | 400 | Zo1 | 400 |
| 1 | 0.15 | 800 | 0.1 | 0.1 | 400 | Zo2 | 200 |
| 2 | 0.15 | 800 | 0.1 | 0.1 | 400 | Zo3 | 133 |
| 3 | 0.15 | 800 | 0.1 | 0.1 | 400 | Zo4 | 100 |
| 4 | 0.15 | 800 | 0.1 | 0.1 | 400 | Zo5 | 80 |
| 5 | 0.15 | 800 | 0.1 | 0.1 | 400 | Zo6 | 67 |
| 6 | 0.15 | 800 | 0.1 | 0.1 | 400 | Zo7 | 57 |
| 7 | 0.15 | 800 | 0.1 | 0.1 | 400 | Zo8 | 50 |
| Total Wgt (mm) | 1.05 | mm | | | | | |
| Output Power (W) | 3.9375 | W | | | | | |

# FIG. 14

# FIG. 15

Net Loss Amount Upon Passage Through Transistor 5

# FIG. 16

FIG. 17

FIG. 18

| Specifications of Transistor | | | Combined Impedance (Ω) | |
|---|---|---|---|---|
| FET number | Wgt (mm) | $R_{opt}$ (Ω) | | |
| 1 | 0.24 | 500 | Zo1 | 500 |
| 2 | 0.24 | 500 | Zo2 | 250 |
| 3 | 0.24 | 500 | Zo3 | 167 |
| 4 | 0.24 | 500 | Zo4 | 125 |
| 5 | 0.24 | 500 | Zo5 | 100 |
| 6 | 0.24 | 500 | Zo6 | 83 |
| 7 | 0.24 | 500 | Zo7 | 71 |
| 8 | 0.24 | 500 | Zo8 | 63 |
| 9 | 0.24 | 500 | Zo9 | 56 |
| 10 | 0.24 | 500 | Zo10 | 50 |
| Total Wgt (mm) | 2.4 | mm | | |

FIG. 19

| Specifications of Transistor | | | Combined Impedance (Ω) | |
|---|---|---|---|---|
| FET number | Wgt (mm) | $R_{opt}$(Ω) | | |
| 1 | 0.3 | 400 | Zo1 | 400 |
| 2 | 0.3 | 400 | Zo2 | 200 |
| 3 | 0.3 | 400 | Zo3 | 133 |
| 4 | 0.3 | 400 | Zo4 | 100 |
| 5 | 0.3 | 400 | Zo5 | 80 |
| 6 | 0.3 | 400 | Zo6 | 67 |
| 7 | 0.3 | 400 | Zo7 | 57 |
| 8 | 0.3 | 400 | Zo8 | 50 |
| Total Wgt (mm) | 2.4 | mm | | |

FIG. 20

| Specifications of Transistor | | | Combined Impedance (Ω) | |
|---|---|---|---|---|
| FET number | Wgt (mm) | $R_{opt}$ (Ω) | | |
| 1 | 0.6 | 200 | Zo1 | 200 |
| 2 | 0.6 | 200 | Zo2 | 100 |
| 3 | 0.6 | 200 | Zo3 | 67 |
| 4 | 0.6 | 200 | Zo4 | 50 |
| Total Wgt (mm) | 2.4 | mm | | |

# FIG. 21

| Specifications of Transistor | | | Combined Impedance ($\Omega$) | |
|---|---|---|---|---|
| FET number | Wgt (mm) | $R_{opt}$ ($\Omega$) | | |
| 1 | 0.6 | 200 | Zo1 | 200 |
| 2 | 0.2 | 600 | Zo2 | 150 |
| 3 | 0.2 | 600 | Zo3 | 120 |
| 4 | 0.2 | 600 | Zo4 | 100 |
| 5 | 0.2 | 600 | Zo5 | 86 |
| 6 | 0.2 | 600 | Zo6 | 75 |
| 7 | 0.2 | 600 | Zo7 | 67 |
| 8 | 0.2 | 600 | Zo8 | 60 |
| 9 | 0.2 | 600 | Zo9 | 55 |
| 10 | 0.2 | 600 | Zo10 | 50 |
| Total Wgt (mm) | 2.4 | mm | | |

## INTERNATIONAL SEARCH REPORT

| International application No. |
| --- |
| PCT/JP2016/064722 |

**A. CLASSIFICATION OF SUBJECT MATTER**
*H03F3/68* (2006.01)i

According to International Patent Classification (IPC) or to both national classification and IPC

**B. FIELDS SEARCHED**

Minimum documentation searched (classification system followed by classification symbols)
H03F3/68

Documentation searched other than minimum documentation to the extent that such documents are included in the fields searched

| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2012-231392 A (Mitsubishi Electric Corp.), 22 November 2012 (22.11.2012), (Family: none) | 1-5 |
| A | WO 2014/178261 A1 (Mitsubishi Electric Corp.), 06 November 2014 (06.11.2014), & US 2016/0099690 A1 & EP 2993784 A1 | 1-5 |

☐ Further documents are listed in the continuation of Box C. ☐ See patent family annex.

| | |
| --- | --- |
| \*    Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>        22 June 2016 (22.06.16) | Date of mailing of the international search report<br>        05 July 2016 (05.07.16) |
| --- | --- |
| Name and mailing address of the ISA/<br>        Japan Patent Office<br>        3-4-3, Kasumigaseki, Chiyoda-ku,<br>        Tokyo 100-8915, Japan | Authorized officer<br><br>Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. CAMPBELL ; L. TAEHUN ; V. WILLIAMS ; K. MING-YIH ; T. HUA-QUEN ; P. SAUNIER.** A Wideband Power Amplifier MMIC Utilizing GaN on SiC HEMT Technology. *2008 CSICS,* October 2008